# EUROPEAN PATENT APPLICATION

(11) **EP 4 668 338 A1**
(43) Date of publication of application: **24.12.2025**
(21) Application number: 24182810.2
(22) Date of filing: 18.06.2024
(51) Int. Cl.: H01L 27/146

(54) **AN IMAGING DEVICE AND A METHOD FOR WAVELENGTH DEPENDENT IMAGING**

(71) Applicant: Imec VZW, 3001 Leuven (BE); Katholieke Universiteit Leuven KU Leuven Research & Development, 3000 Leuven (BE)
(72) Inventor: GEHLHAAR, Robert, 3020 Herent (BE); SHRAMKOVA, Oksana, 3020 Herent (BE); ALI, Farhan, 3000 Leuven (BE); MAC CIARNAIN, Rossa, 3010 Leuven (BE); GENOE, Jan, 3272 Testelt (BE); FIGEYS, Bruno, 3001 Heverlee (BE)
(74) Representative: AWA Sweden AB

(57) **Abstract**

An imaging device (100) for wavelength dependent imaging comprising: a semiconductor substrate (102); a detector (110) configured to detect light; a plurality of light propagating units (120) arranged integrated on the semiconductor substrate (102), wherein each light propagating unit (120) comprises: a waveguide (140) being a multimode waveguide configured to propagate the light through the waveguide (140) in dependence of wavelength such that a spatial distribution of the light at the distributing end (144) is dependent on wavelength of the light; wherein the waveguide (140) has a cross-section with an elongate shape, wherein the waveguides (140) of the plurality of light propagating units (120) are arranged with different orientations on the semiconductor substrate (102) such that the elongate shape of a first waveguide of a first light propagating unit is rotated in relation to the elongate shape of a second waveguide of a second light propagating unit.

## Description

### Technical field

The present description relates to imaging, and more specifically to an imaging device and a method for providing imaging that acquires wavelength information.

### Background

Imaging techniques using detection of several wavelength bands of light within the ultraviolet, visible, and infrared spectral ranges, have found widespread application ranging from multi-spectral detection for scientific measurements to photographic imaging. In order to distinguish between light of different wavelength bands, imaging devices such as digital cameras typically comprise filter arrays covering pixels, to filter out certain wavelength bands. Thus, different pixels detect light intensity within different wavelength bands of the full light spectrum. A common example is cameras for photography comprising filter arrays for the colors red, green, and blue, allowing the three separate colors to be detected by respective pixels of the imaging device. The acquired signals from the different pixels may be used for representing intensity of the respective wavelength bands, and based on the measured intensities the wavelength composition of the incident light may be estimated.

However, conventional filters reduce the intensity of the incident light before light reaches a detector comprising light sensitive elements, thereby effectively reducing the sensitivity of the imaging device. This implies that using filters, there are limitations related to downscaling of optical components, since the intensity incident on a detector associated with a pixel may become too small to allow detection if the size of the pixel is reduced. In particular, if size of the pixel is smaller than size of a photon, the sensitivity is further reduced, since the photon will overlap with neighboring pixels and partially absorbed by pixels for which a transmission band does not coincide with wavelength of the photon.

EP 3770660 discloses an imaging device comprising waveguides for separating the incident light into wavelength bands. Based on a light separation principle using waveguides, rather than based on a principle of absorption or reflection, incident light is not discarded from reaching the detector to any large extent, but rather split into a number of wavelength bands. This implies that a major portion of incident light is allowed to reach a detector so as to be detected. As less light is discarded in a filtering process for separating light of different wavelengths, overall light sensitivity of the imaging device is increased.

However, the waveguides used for separating light into different wavelength bands, may be relatively long. Further, the waveguides are arranged on the detector, such that light is guided by the waveguides from a first plane on which light is incident to a second plane in which the light sensitive elements of the detector are arranged. This implies that a waveguide layer comprising the waveguides may be relatively thick, such as having a thickness of at least 1 µm.

The waveguide layer may be arranged on a semiconductor substrate with which the detector comprising the light sensitive elements is integrated. Since the waveguide layer is relatively thick, there may be challenges in manufacturing of the imaging device. In particular, the manufacturing of many waveguides in parallel on the semiconductor substrate may be challenging.

### Summary

An objective of the present description is to provide an imaging device being configured to provide efficient wavelength dependent imaging, wherein the imaging device is further design to facilitate manufacturability of the imaging device. A further objective of the present description is to provide an imaging device that enables polarization independent imaging.

These and other objectives are at least partly met by the invention as defined in the independent claims. Preferred embodiments are set out in the dependent claims.

According to the present description, there is an insight that the manufacturing of waveguides on the semiconductor substrate may cause high mechanical stress in the waveguide layer. Such mechanical stress may result in bow and warp of a semiconductor wafer on which a plurality of imaging devices may be manufactured in parallel, or even in cracks being formed in the semiconductor wafer. Thus, the semiconductor wafer may become deformed so that flatness of the semiconductor wafer is not maintained. If cracks are formed in the semiconductor wafer, the imaging devices manufactured on the semiconductor wafer are damaged and need to be discarded.

Semiconductor wafer bow and warp may impact handling of the semiconductor wafer. In particular, accuracy and precision in manufacturing of the imaging device may be affected. For instance, the deformation of the semiconductor wafer implies that locations of structures on the semiconductor wafer may not be accurately known. Thus, the locations of ends of the waveguides facing away from the substrate may not be accurately known. Hence, it may be very difficult to accurately form structures in relation to such ends of the waveguides. If bow or warp of the wafer become too large, the semiconductor wafer may not even be processed at all.

Misplacement of structures in relation to each other may cause functionality of imaging devices to be affected such that quality of function of the imaging devices may be reduced (for instance, wavelength bands may not be properly separated), or even that the imaging devices may not provide a correct function such that the imaging devices may need to be discarded.

Semiconductor wafer bow and warp may thus reduce yield in manufacturing or may require accurate control of the manufacturing process so as to complicate the manufacturing process.

It is a further insight of the present description that the imaging device may be configured to avoid or reduce material anisotropy in the waveguide layer. Thanks to avoiding or reducing material anisotropy, the mechanical stress in the waveguide layer may be reduced such that bow and warp of the semiconductor wafer may be avoided or reduced. This implies that the imaging device may be designed to facilitate manufacturability.

According to a first aspect, there is provided an imaging device for wavelength dependent imaging, the imaging device comprising: a semiconductor substrate comprising a first surface; a detector comprising a plurality of light sensitive elements integrated with the first surface of the semiconductor substrate, wherein each light sensitive element is configured to generate an electric signal dependent on an intensity of light incident onto the light sensitive element; a plurality of light propagating units arranged integrated on the first surface of the semiconductor substrate above the plurality of light sensitive elements, wherein each light propagating unit of the plurality of light propagating units comprises: a light collecting element having a collecting end and a transmitting end, the light collecting element being configured to collect light incident at the collecting end and to propagate the light to the transmitting end; a waveguide having a receiving end and a distributing end, the waveguide being configured to receive the light from the transmitting end at the receiving end and to propagate the light to the distributing end, wherein the waveguide is a multimode waveguide configured to propagate the light through the waveguide in dependence of wavelength such that a spatial distribution of the light at the distributing end is dependent on wavelength of the light; wherein the waveguide has a cross-section parallel to the first surface, wherein the cross-section has an elongate shape defining a first size of the cross-section in a first direction and a second size of the cross-section in a second direction perpendicular to the first direction, wherein the first size is larger than the second size; wherein the waveguides of the plurality of light propagating units are arranged with different orientations on the first surface of the semiconductor substrate such that a first waveguide of a first light propagating unit is rotated in relation to a second waveguide of a second light propagating unit defining an angle between the first direction of the first light propagating unit and the first direction of the second light propagating unit.

According to the imaging device according to the first aspect, the waveguides are arranged with different orientations on the semiconductor substrate. Thus, even though the waveguides have different sizes in the first and second directions, the arrangement of a plurality of waveguides on the semiconductor substrate may be provided so as to reduce material anisotropy. In particular, since the first directions of all the waveguides are not aligned on the semiconductor substrate, the mechanical stress in a waveguide layer in which the waveguides are formed may be reduced.

Hence, thanks to the imaging device of the first aspect, bow and warp may be avoided, such that the handling of the imaging device during manufacturing may be greatly improved.

Thus, the imaging device is configured so as to provide a high yield in manufacturing of the imaging device. Also, the imaging device is configured so as to facilitate manufacturing of many imaging devices on a common semiconductor wafer. In addition, the imaging device is configured so as to provide high quality of function of the imaging device since structures may be very accurately formed in relation to each other.

The waveguides may be configured to provide polarization dependent propagation of light. In particular, the orientation of the first direction of the elongate shape of the waveguide may determine what linear polarization direction of light that will propagate through the waveguide. It should be realized that the waveguide providing polarization dependent propagation of light does not imply that only light of a particular linear polarization may be propagated through the waveguide. However, the waveguide may be substantially selective to a particular linear polarization direction.

Thanks to the waveguides of the plurality of light propagating units having different orientations, the waveguides of different light propagating units may be selective to different linear polarization directions. This implies that the imaging device will not be selective to detection of one particular linear polarization direction, such that the imaging provided by the imaging device will not be highly polarization dependent.

By the term "wavelength dependent imaging" is here meant detection of light such that for each of a plurality of spatial positions on an imaged object or scene, information related to the wavelength of the light from the corresponding spatial position is detected.

In this context the term "light" should be allowed a broad interpretation, not limited to visible electromagnetic radiation. Rather, the term "light" may also include for example ultraviolet light, infrared light, or combinations thereof.

By the term "semiconductor substrate" is here meant a carrier structure with which structures may be integrated for forming the imaging device. The semiconductor substrate may typically be planar having a uniform thickness perpendicular to the planar extension. It should be realized that the plurality of light propagating units may be manufactured directly on the semiconductor substrate with which the detector is integrated. However, according to an alternative, the plurality of light propagating units may be manufactured on a separate substrate acting as a carrier substrate during manufacturing of the light propagating units. Then, after the light propagating units have been formed, the light propagating units may be bonded to the semiconductor substrate.

The semiconductor substrate or a separate carrier substrate may be part of a semiconductor wafer during manufacturing such that light propagating units associated with a plurality of imaging devices may be manufactured on the same semiconductor wafer, which may be diced after forming of the light propagating units on the wafer such that separate groups of light propagating units for different imaging devices are provided. Thus, the semiconductor substrate or the separate carrier substrate may correspond to the part of the semiconductor wafer that is associated with the imaging device.

The semiconductor wafer may for instance be circular with a diameter of 200 mm or 300 mm so as to be adapted to sizes handled by semiconductor manufacturing plants. However, it should be realized that other sizes of semiconductor wafers are handled by existing semiconductor manufacturing plants and that the imaging device may be formed by handling a semiconductor wafer of any size.

Further, it should be realized that the imaging device need not necessarily be manufactured on a semiconductor wafer and that the semiconductor substrate may have a desired size even before structures are integrated with the semiconductor substrate.

The semiconductor substrate may present a first surface. The first surface may be a surface of the semiconductor substrate along the planar extension of the semiconductor substrate.

The semiconductor substrate may be formed by any semiconductor material. For instance, the semiconductor substrate may be formed by a single semiconductor element, such as silicon or germanium. However, the semiconductor substrate may alternatively be formed by a compound semiconductor, such as a III-V compound semiconductor. For instance, the semiconductor substrate may be formed by gallium arsenide. According to yet another alternative, the semiconductor substrate may comprise a thin layer of a semiconductor material, wherein the thin layer may be arranged on a thicker substrate layer providing mechanical support. Thus, the semiconductor substrate may for instance be formed by a silicon on insulator (SOI) structure.

By the term "light sensitive element" is here meant an element reacting to light impinging onto the element, by generating an electric signal as a response to the light intensity. A plurality of light sensitive elements may be arranged on a detector, configured to allow read-out of the electric signals representing light for image acquisition. Given as non-limiting examples, light sensitive elements may be found on photodiodes, photo-multiplier tubes (PMT), and pixels on image detectors such as charge-coupled devices (CCD) and complementary metal oxide semiconductors (CMOS). By way of example, a plurality of light sensitive elements may be in the form of pixels on a CCD or CMOS detector but may alternatively comprise a plurality of any other type of light sensitive elements.

By way of example, the plurality of light sensitive elements may be arranged in a plane of the detector. By way of further example, the plane may be a planar surface of the detector.

The plurality of light sensitive elements may be integrated with the first surface of the semiconductor substrate by the light sensitive elements being formed in the semiconductor substrate or arranged in a layer integrated with the semiconductor substrate. The light sensitive elements may for instance be formed by providing regions of different characteristics within the semiconductor substrate, e.g., by having different doping in different regions. This may be used for forming a light sensitive element within the semiconductor substrate.

However, the light sensitive elements may according to an alternative be formed in a photoactive layer including the light sensitive elements. The photoactive layer may further be electrically connected to the semiconductor substrate. Thus, the photoactive layer may be integrated on the semiconductor substrate, such as being directly integrated on the first surface or with one or more additional layers being arranged between the first surface of the semiconductor substrate and the photoactive layer.

The semiconductor substrate may be further provided with electronic circuitry integrated with the substrate. The electronic circuitry may be connected to the light sensitive elements for providing read-out of the electric signals generated by the light sensitive elements. The electronic circuitry may further be configured to process the read out electric signals.

According to an embodiment, the plurality of light sensitive elements is arranged in an array forming an array of light sensitive elements. Thus, the plurality of light sensitive elements may be arranged in a regular manner. This may facilitate manufacturing of the detector.

By way of example, the light sensitive elements may be arranged in rows and columns forming the array of light sensitive elements. Typically, a light sensitive element is in the shape of a square, however it is conceivable that the light sensitive element may alternatively be of another shape, such as a rectangular, circular, or elliptical shape.

However, it should be realized that the plurality of light sensitive elements need not be arranged in a regular manner and that different light sensitive elements may have different sizes and/or shapes.

By the term "light propagating unit" is here meant any unit, device, and/or element with the capability of propagating light based on the wavelength of the light.

Given only as an example, incident light of several wavelengths may be propagated through the light propagating unit such that different wavelengths are provided with different spatial distribution of intensity, by having a direction of propagation altered based on the wavelength of the light, such that different wavelengths take different directions. By the present arrangement, different wavelengths may reach different locations of the distributing end. It should, however, be realized that the light propagating unit may not necessarily completely separate different wavelengths in different directions. Rather, the light propagating unit may provide a spatial distribution of light in a cross-section of the light propagating unit (such as at the distributing end), wherein the spatial distribution of light is different for different wavelengths. However, it is conceivable that incident light of several wavelengths may, alternatively, be fully separated by having a direction of propagation altered based on the wavelength of the light, such that different wavelengths take different directions.

The light propagating unit comprises a light collecting element having a collecting end and a transmitting end. The light collecting element is configured to collect light incident at the collecting end and to propagate the collected light to the transmitting end.

The light collecting element is configured to collect light incident at the collecting end and to propagate the collected light to the transmitting end. The light collecting element may further be configured to concentrate the light at the transmitting end. The light collecting element may have a straight shape along the extension from the collecting end to the transmitting end, or the light collecting element may alternatively have a tapered shape or a widening shape along the extension from the collecting end to the transmitting end. By way of example, the light collecting element may be shaped such that the light may be concentrated to a very small area at the transmitting end having a size in the same order of magnitude as the wavelength of the light. By way of example, the transmitting end may have a width of about 340 nm. By way of further example, a width of the collecting end may be around 220 nm.

The cross-section of the light collecting element may be in the shape of a square. However, it is conceivable that the cross-section of the light collecting element may alternatively be of another shape, such as a rectangular, triangular, circular, or elliptical shape. Thus, the light collecting element in full may have a shape of a cylinder, sphere, half-sphere, cube, pyramid, or any other suitable shape.

The light collecting element may be configured to concentrate the light at the transmitting end, and thus at, or close to, the receiving end of the waveguide. By the present arrangement, the light may be coupled into the waveguide from the light collecting element such that specific modes may be excited in the waveguide.

Given as a non-limiting example, the light collecting element may be in the form of a dielectric micro-element. The light collecting element may be configured to concentrate the light by providing a photonic nano-jet.

It should be understood that the light collecting element may also be arranged in a host medium. The host medium surrounding the light collecting element may be of the same type as a host medium surrounding the waveguide, or it may alternatively be of a different type. As yet another alternative, the light collecting element may be without a host medium arranged around it. In such a case it is conceivable that the light collecting element is instead surrounded by an ambient medium of the environment wherein the imaging device is located. The ambient medium may function as a host medium even though it is not part of the imaging device as such. By way of example, such an ambient medium surrounding the light collecting element may be ambient air.

According to another embodiment, the light collecting element may be a funnel element having a tapered shape. In order for the collecting end to collect as much light as possible, the cross-section of the collecting end is large. The funnel element is tapered such that the cross-section of the collecting end is larger than the cross-section of the transmitting end. By way of example, the funnel element may be tapered such that the light may be confined to a very small area at the transmitting end having a size in the same order of magnitude as the wavelength of the light. By way of example, the transmitting end may have a width in the range of 200 nm to 600 nm. By way of further example, a width of the collecting end may be adapted to collect as much light as possible to the light sensitive elements. The width of the collecting end may thus be adapted to fill a plane onto which light is incident. Hence, the width of the collecting end may be dependent on size of light sensitive elements associated with the light propagating unit. If the size of the light sensitive elements is 500 nm, the width of the collecting end may be approximately 700 nm, if the collecting end is rotated as discussed below. If the size of the light sensitive elements is 1 µm, the width of the collecting end may be approximately 1.4 µm.

The light propagating unit further comprises a waveguide having a receiving end and a distributing end. The waveguide is configured to receive the light from the transmitting end at the receiving end of the waveguide. The waveguide may have a cross-section at the receiving end that is smaller than the cross-section of the collecting end of the funnel element. Thus, in order for all light collected at the collecting end to be coupled into the waveguide, the funnel element is tapered such that the transmitting end of the funnel element has a cross-section that is not larger than the cross-section of the receiving end of the waveguide. Typically, the funnel element is tapered such that the transmitting end of the funnel element has a cross-section that is smaller than the cross-section of the receiving end of the waveguide. By the present arrangement, an efficient stacking of the elements facilitating coupling most of the light, and preferably all the light, into the respective light sensitive elements of the detector may be provided.

The receiving end may be facing the transmitting end. The receiving end may be in direct physical contact with the transmitting end. Alternatively, a gap may be formed between the receiving end and the transmitting end. As yet another alternative, the light propagating unit may be made of a single piece of material such that the funnel element and the waveguide are different portions of the single piece.

By way of example, one or more additional layers may be provided between the transmitting end and the receiving end. By way of example, the one or more additional layers may enhance the coupling of light between the funnel element and the waveguide.

The waveguide is further configured to propagate the light from the receiving end to the distributing end. The waveguide may be, but is not required to be, tapered from the receiving end to the distributing end such that a cross-section of the receiving end is larger than a cross-section of the distributing end. Alternatively, the sides of the waveguide may be parallel. As the waveguide is a multimode waveguide, the waveguide will propagate the light through the waveguide in dependence of wavelength. In this manner, the distribution of the light at the distributing end is dependent on the wavelength content of the light.

Each light propagating unit is arranged with respect to the detector such that the light at the distributing end is incident onto at least two light sensitive elements of the plurality of light sensitive elements.

Each of the light sensitive elements in combination with a light propagation unit may be arranged to capture light of at least one specific wavelength band. By using at least two light sensitive elements, detection of at least two different wavelength bands may be provided. The incident light may thus be distributed by the propagation through the waveguide being wavelength dependent, such that different wavelengths are differently distributed in relation to the light sensitive elements on the detector.

By way of example, the light propagating unit may be made of a material with a refractive index higher than a refractive index of a surrounding medium. Given as a non-limiting example, the light propagating unit may be made of silicon nitride with a refractive index of about 2.0. The surrounding medium may be made of an oxide with a lower refractive index. By the present arrangement, absorption of light in the light propagating unit may be avoided. Thus, most of the light, and preferably all the light, collected at the collecting end of the light collecting element may be coupled to the receiving end of the waveguide. Multimode interference in the waveguide leads to a wavelength dependent beating of the light, resulting in spatial distribution of the light at different locations of the distributing end dependent on wavelength of the light. By the present arrangement, substantially all light collected at the collecting end is propagated through the light collecting element to the transmitting end and coupled into the waveguide, such that substantially all light collected will be distributed through the distributing end and will be incident onto a light sensitive element of the detector.

It should be realized that the term "all light" is here referring to all the light withing the wavelength range for which the imaging device and the light propagating units are designed to function. By way of example, the imaging device and the light propagating units may be designed to work for light within the wavelength range of 400-700 nm. Incident light outside the working wavelength range may not necessarily be collected and guided into the light collecting element. For example, such light may alternatively be reflected, absorbed, or scattered by the light propagating units.

Light incident on the light propagating unit is first propagated by the light collecting element and thereafter propagated by the waveguide towards the light sensitive elements. This implies that the waveguide of a light propagating unit is arranged between the light collecting element and the light sensitive elements.

As mentioned above, the plurality of light sensitive elements may be arranged in a plane of the detector. Further, the plane may be a planar surface of the detector. Each light propagating unit of the plurality of the light propagating units may extend in a direction substantially perpendicular to the plane. More specifically, an optical axis through the light propagating unit, corresponding to the main direction of light propagation may extend substantially perpendicular to the plane of light sensitive elements. The optical axis of the light collecting element may be collinear with the optical axis of the waveguide. However, it should be realized that the light collecting element may be asymmetrically coupled to the waveguide, such that the optical axis of the light collecting element is displaced from an optical axis of the waveguide, while the optical axes of the light collecting element and the waveguide are parallel.

The light propagating units may be arranged such that the collecting end of the light collecting element is facing away from the detector, and such that the transmitting end of the light collecting element is facing towards the detector. At the transmitting end of the light collecting element, the waveguide may be arranged such that the receiving end faces away from the detector and thus facing the transmitting end of the light collecting element. Further, the distributing end of the waveguide may be facing the plurality of light sensitive elements of the detector.

By way of example, the waveguide and the detector may be arranged such that a gap is formed between the distributing end and the light sensitive elements, or the distributing end and the light sensitive elements may be arranged to be in direct physical contact with each other. In some embodiments, one or more additional layers may be provided between the distributing end and the light sensitive elements. By way of example, the one or more additional layers may enhance the coupling of light between the waveguide and the detector.

The material of which the light collecting element and/or waveguide of the light propagating unit is made of may depend on the wavelength range for which the light propagating unit is designed. Given as non-limiting examples, if the light propagating unit is designed for propagation of visible light, materials such as silicon nitride (SiN), titanium oxide (TiOₓ), or niobium oxide (NbOₓ) may be used in a silicon oxide (SiOₓ) environment. Given as further non-limiting examples, if the light propagating unit is designed for propagation of light in the near infrared (NIR) range, materials such as amorphous silicon, or carbon rich amorphous silicon may be used. It should be realized that different parts of the light propagating unit may be formed by different optical materials or by the same optical material.

It should be realized that the waveguide may be formed by a homogeneous material extending through the extension of the waveguide from the receiving end to the distributing end. However, there may alternatively be a (thin) material layer arranged within the waveguide. Such material layer may extend through the entire imaging device, or at least across a plurality of light propagating units and may be provided in order to facilitate forming of a waveguide having a large height (i.e., a long distance between the receiving end and the distributing end). The material layer should be formed by a material that is transparent to light to be detected and may be configured not to affect the light propagation provided by the waveguide. For instance, the material layer may be formed by silicon carbon nitride (SiCN).

The light propagating units are integrated on the first surface of the semiconductor substrate. This implies that the light propagating units may be directly integrated on the semiconductor substrate. However, according to an alternative, one or more intermediate layers may be arranged between the light propagating units and the semiconductor substrate. For instance, the light sensitive elements of the detector may not be formed in the semiconductor substrate such that the detector may comprise one or more layers arranged between the semiconductor substrate and the light propagating units.

It should be realized that each light propagating unit comprises a light collecting element and a waveguide. Thus, the first light propagating unit comprises a first light collecting element and first waveguide, and the second light propagating unit comprises a second light collecting element and a second waveguide. Hence, the first light collecting element is different from the second light collecting element. In addition, the imaging device may be provided with a one-to-one relation between light collecting elements and waveguides, such that each waveguide is associated with a unique light collecting element.

As mentioned above, the cross-section of the waveguide may be tapered from the receiving end to the distributing end such that a cross-section of the receiving end is larger than a cross-section of the distributing end. Alternatively, the sides of the waveguide may be parallel. Regardless, the waveguide may be arranged such that in each cross-section, the waveguide has an elongate shape.

The waveguide having an elongate shape implies that the waveguide has different sizes of extension in perpendicular directions of the cross-section. For instance, the cross-section of the waveguide may be rectangular with a first size corresponding to a length of a first side of the rectangle and a second size corresponding to a width of a second side of the rectangle. Alternatively, the cross-section of the waveguide may be elliptic with a first size corresponding to a size of a major axis of the ellipse and a second size corresponding to a size of a minor axis of the ellipse. However, it should be realized that the waveguide need not necessarily have any shape, which need not necessarily be a regular shape. The first direction may be defined as a direction along which a maximum size of the cross-section may be provided with the second direction being perpendicular to the first direction.

Thanks to the elongate shapes being differently arranged, the material anisotropy in a layer in which the plurality of waveguides is arranged is reduced.

The waveguides of the plurality of light propagating units being arranged with different orientations imply that the first direction of the waveguides may be arranged to extend in a plurality of different directions. However, the plurality of light propagating units may be arranged such that two different orientations are defined, with each light propagating unit being arranged with its waveguide being oriented according one of the two different orientations.

The first waveguide being rotated in relation to the second waveguide implies that the first direction of the first waveguide is not aligned with the first direction of the second waveguide. This implies that the first directions of the waveguides are not parallel. Hence, an angle defined between the first direction of the first light propagating unit and the first direction of the second light propagating unit will be an angle between 0° and 180°, and not including the end points of 0° or 180°.

It should be realized that material anisotropy may be avoided to a high extent if the angle between the first direction of the first light propagating unit and the first direction of the second light propagating unit is 90°. Also, the relation of the first light propagating unit and the second light propagating unit to different light sensitive elements arranged in a regularly ordered two-dimensional array would be facilitated by the angle being 90°. However, it should be realized that the angle need not necessarily be exactly 90°. For instance, the angle may slightly deviate from 90° while still providing suitable wavelength dependent propagation of light to the plurality of light sensitive element. For instance, the angle may be in a range of 85-95°. In addition, one of the light propagating units may be configured to be arranged along a diagonal in the array of light sensitive elements. In such case, the angle may be 45° or 135°, or in a range around 45° or 135°, such as in a range of 40-50° or in a range of 130-140°. Also, it should be realized that if the plurality of light sensitive elements is not arranged in a regularly ordered manner, the angle between the first direction of the first light propagating unit and the first direction of the second light propagating unit may be more freely selected.

It should be further realized that the light propagating units are not necessarily provided with identical waveguides. For instance, all of the waveguides may have an elongate shape, but the elongate shapes need not be exactly identical. The first waveguide may have a larger size than the second waveguide, such that the first size of the first waveguide is different from the first size of the second waveguide. The waveguides may be adapted to provide different spatial distributions of light at the respective distributing ends, which may imply that dimensions of the waveguides may need to slightly differ.

According to an embodiment, the plurality of light propagating units comprises a first set of light propagating units and a second set of light propagating units, wherein the waveguides of the light propagating units of the first set are arranged with a first orientation, wherein the first direction of the elongate shape is aligned with a direction of a row of the light sensitive elements, wherein the waveguides of the light propagating units of the second set are arranged with a second orientation, wherein the first direction of the elongate shape is aligned with a direction of a column of the light sensitive elements, wherein the light propagating units of the first set are intermixed with the light propagating units of the second set on the semiconductor substrate.

This provides a regular order of the light propagating units while having waveguides arranged with different orientations in the imaging device.

The number of light propagating units in the first set may be equal to the number of light propagating units in the second set. This may be advantageous in ensuring that material anisotropy in a layer comprising the plurality of waveguides is avoided. However, it should be realized that the numbers of light propagating units of the sets are not necessarily equal.

Since the waveguides of the light propagating units are aligned with columns and rows, respectively, the angle defined between the first direction of the first light propagating unit and the first direction of the second light propagating unit will be 90°, or at least approximately 90°. This implies that the first waveguide and the second waveguide may be selective to propagate light having linear polarization directions that are perpendicular to each other. Hence, the imaging device may provide polarization independent imaging.

Thanks to the light propagating units of the first set being intermixed with the light propagating units of the second set, the waveguides having same orientations are not grouped in a single region. Thus, the arranging of the waveguides may also avoid material anisotropy locally in regions of the imaging device.

According to an embodiment, each light propagation unit is associated with at least two light sensitive elements arranged along a straight line, wherein the spatial distribution of the light at the distributing end of the waveguide is incident onto the at least two light sensitive elements.

The light propagation unit is configured to provide a spatial distribution of the light at the distributing end of the waveguide, wherein the different wavelengths of light are differently distributed at the distributing end. This implies that the light sensitive elements with which the light propagation unit is associated will receive different spectral compositions of light, in that light of different wavelength bands will have a higher concentration in different spatial positions. Thanks to the light propagation unit being associated with at least two light sensitive elements, the electric signals generated by different light sensitive elements may be used for representing spectral information of incident light.

The at least two light sensitive elements may be arranged along a straight line that coincides with a projection of the first direction of the waveguide onto the plane of the detector. Thus, the orientation of the waveguide such that the first direction is aligned with a row or a column of the light sensitive elements implies that the light sensitive elements in the row or the column will be configured to detect information relating to different wavelength bands.

It should be realized that different light propagating units may be provided with different characteristics of the waveguides, such as the first and/or second sizes of the cross-sections differing for different waveguides. This implies that different spatial distributions of light may be provided such that light propagating units of different types distribute spectral content of light in different manners. Hence, the different types of light propagating units may be associated with light sensitive elements to provide different spectral information, such that the electric signals generated by the light sensitive elements may be used for representing spectral information of incident light, wherein different spectral information is provided by different types of light propagating units.

For instance, a first type of light propagating unit may be configured to separate light based on a first wavelength crossing point and a second type of light propagating unit may be configured to separate light based on a second wavelength crossing point. The first type of light propagating unit may preferentially provide light having a wavelength below the first wavelength crossing point at a first spatial position associated with a first light sensitive element and may preferentially provide light having a wavelength above the first wavelength crossing point at a second spatial position associated with a second light sensitive element. Similarly, the second type of light propagating unit may preferentially provide light having a wavelength below the second wavelength crossing point at a third spatial position associated with a third light sensitive element and may preferentially provide light having a wavelength above the second wavelength crossing point at a fourth spatial position associated with a fourth light sensitive element. Thus, the first, second, third, and fourth light sensitive elements will each detect different spectral ranges of light. The spectral ranges may partially overlap. However, the electric signals generated by the first, second, third, and fourth light sensitive elements may be used for providing spectral information in the imaging by the imaging device.

According to an embodiment providing spectral information in the range of visible light, the first wavelength crossing point may be set to a relatively large value close to or corresponding to red light and the second wavelength crossing point may be set to a relatively small value close to or corresponding to blue light. For instance, the first wavelength crossing point may be set in an interval of 560-600 nm, such as approximately 580 nm, and the second wavelength crossing point may be set in an interval of 460-500 nm, such as approximately 480 nm. The electric signals generated by the first and second light sensitive elements may then be considered to represent red and cyan light, respectively, whereas the electric signals generated by the third and fourth light sensitive elements may then be considered to represent blue and yellow, respectively.

It should be realized, however, that a light propagating unit may be configured to spatially distribute light of different wavelengths such that there is a gradual variation of concentration of different wavelength bands of light along the distributing end. This implies that the light propagating unit may be associated with more than two light sensitive elements, which may each be configured to generate an electric signal that may be considered to represent a specific wavelength band, such as providing a representation of red, green, and blue light.

It should be realized that the first set of light propagating units having waveguides arranged with a first orientation may include both first and second types of light propagating units. Similarly, the second set of light propagating units having waveguides arranged with a second orientation may include both first and second types of light propagating units. However, according to an alternative, the first set of light propagating units includes only the first type of light propagating unit, and the second set of light propagating units includes only the second type of light propagating unit.

It should be realized that all light sensitive elements may be identical. This implies that the spectral information is solely provided by the propagation of light to different light sensitive elements in dependence of wavelength and is not based on light sensitive elements being selectively sensitive to different wavelength bands. However, according to an alternative, different light sensitive elements have different sensitivity to wavelengths of light. Thus, spectral information may be further enhanced by the sensitivity of the light sensitive elements.

According to an embodiment, the plurality of light sensitive elements and the plurality of light propagating units are arranged in unit cells that are repeated across the first surface of the semiconductor substrate, wherein each unit cell includes an equal number of light propagating units belonging to the first set and light propagating units belonging to the second set.

The unit cells may provide spatial information in imaging by the imaging device. Thus, each unit cell may represent a single spatial point in an image generated by the imaging device. Further, the propagation of light in dependence of wavelength by the plurality of light propagating units in the unit cell may represent a spectral resolution in the single spatial point represented by the unit cell.

Thanks to the unit cell including an equal number of light propagating units belonging to the first and second sets, respectively, there is material anisotropy may be avoided locally within each unit cell. Since the unit cells are further repeated across the semiconductor substrate material anisotropy may be avoided throughout the layer in which the plurality of waveguides is arranged.

It should be realized that the unit cells may be logically defined based on processing of the electric signals generated by the light sensitive elements. Thus, a processor configured to generate an image based on information read out from the light sensitive elements may combine electric signals from plural light sensitive elements. Thus, the electric signals from light sensitive elements of a unit cell may be combined by a processor to form a single pixel of the image.

Thus, it should be realized that a light propagating unit may not necessarily be solely associated with a single unit cell. Rather, the light propagating unit may be associated with light sensitive elements that are assigned to different unit cells.

In addition, it should be realized that the light sensitive elements may not necessarily be associated with a single unit cell. Rather, the electric signal generated by a light sensitive element may be taken into account for representing light detection by more than one unit cell.

According to an embodiment, each unit cell has a rectangular shape.

This implies that the light propagating units are arranged according to a pattern enabling simple interpretation of the electric signals generated by the light sensitive elements.

According to another embodiment, each unit cell has a shape corresponding to two L-shapes being arranged next to each other with long legs of the L-shapes being parallel and short legs of the L-shapes being parallel.

The L-shape may be defined by a light propagating unit of the first set being associated with two light sensitive elements on the same row and a light propagating unit of the second set being associated with another light sensitive element on the same row, as well as a light sensitive element on an adjacent row. The use of the L-shapes allows light propagating units to be uniquely associated with a unit cell. The use of two L-shapes allows light propagating units of a first and a second type to be associated with the unit cell.

The unit cells may be associated with two unit vectors, each defining a displacement between a center of a unit cell to a center of an adjacent unit cell. The unit vectors define a pattern of how the unit cells are repeated across the first surface of the semiconductor substrate. Having two L-shapes in the unit cell may be used for defining unit cells that are associated with perpendicular unit vectors.

According to an embodiment, the light detecting elements of each unit cell are configured to detect light in four different wavelength ranges of visible light for providing spatial and spectral resolution of imaging.

It should be realized that the four different wavelength ranges may be partially overlapping.

The imaging device may thus be configured to provide high spectral resolution of imaging. Further, thanks to the imaging device providing spectral resolution based on propagation of light, the imaging is provided without discarding incident light to any large extent (e.g., by spectral filters), such that the imaging device provides spectral resolution with a high sensitivity to incident light.

According to an embodiment, the light collecting element is a funnel element, wherein a cross-section of the collecting end is larger than a cross-section of the transmitting end.

This may ensure that the imaging device collects as much light as possible since the collecting ends of the funnel elements may be configured to, at least to a large extent, fill a plane onto which the light is incident. Further, the funnel element ensures that light is coupled into the waveguide such that a spatial distribution of light at the distributing end of the waveguide is dependent on wavelength of light.

According to a second aspect, there is provided an imaging device for wavelength dependent imaging, the imaging device comprising: a semiconductor substrate comprising a first surface; a detector comprising a plurality of light sensitive elements integrated with the first surface of the semiconductor substrate, wherein each light sensitive element is configured to generate an electric signal dependent on an intensity of light incident onto the light sensitive element; a plurality of light propagating units arranged integrated on the first surface of the semiconductor substrate above the plurality of light sensitive elements, wherein each light propagating unit of the plurality of light propagating units comprises: a funnel element having a collecting end and a transmitting end, the funnel element being configured to collect light incident at the collecting end and to propagate the light to the transmitting end, wherein a cross-section of the collecting end is larger than a cross-section of the transmitting end; a waveguide having a receiving end and a distributing end, the waveguide being configured to receive the light from the transmitting end at the receiving end and to propagate the light to the distributing end, wherein the waveguide is a multimode waveguide configured to propagate the light through the waveguide in dependence of wavelength such that a spatial distribution of the light at the distributing end is dependent on wavelength of the light; wherein each waveguide of the plurality of light propagating units has a cross-section parallel to the first surface, wherein the cross-section has a symmetrical shape defining a first size of the cross-section in a first direction and a second size of the cross-section in a second direction perpendicular to the first direction, wherein the first size is equal to the second size.

According to the imaging device of the second aspect, the waveguides have a symmetrical shape of the cross-section. This implies that the waveguides extend equally in the first and second directions so as to reduce material anisotropy. This implies that the mechanical stress in a waveguide layer in which the waveguides are formed may be reduced.

Hence, thanks to the imaging device of the first aspect, bow and warp may be avoided, such that the handling of the imaging device during manufacturing may be greatly improved.

Thus, the imaging device is configured so as to provide a high yield in manufacturing of the imaging device. Also, the imaging device is configured so as to facilitate manufacturing of many imaging devices on a common semiconductor wafer. In addition, the imaging device is configured so as to provide high quality of function of the imaging device since structures may be very accurately formed in relation to each other.

The waveguides may further be configured to provide polarization independent detection of light. In particular, thanks to the symmetrical shape of the cross-section of the waveguides, the waveguides may not be selective to propagation of a particular polarization of light.

Thus, the imaging device of the second aspect provides similar advantages to the imaging device of the first aspect.

It should be realized that interpretation of features described above in relation to the first aspect also apply to the imaging device of the second aspect.

The waveguide may be, but is not required to be, tapered from the receiving end to the distributing end such that a cross-section of the receiving end is larger than a cross-section of the distributing end. Alternatively, the sides of the waveguide may be parallel. Regardless, the waveguide may be arranged such that in each cross-section, the waveguide has a symmetrical shape.

According to an embodiment of the second aspect, each light propagation unit is associated with at least four light sensitive elements arranged in a square configuration in the detector with the first and second directions of the waveguide parallel with respective sides of the square configuration, wherein the spatial distribution of the light at the distributing end of the waveguide is incident onto the at least four light sensitive elements.

The symmetrical shape of the cross-section of the waveguide is suited for the light propagation unit to be associated with light sensitive elements being arranged in a square configuration.

The waveguide may be configured to propagate light to provide a spatial distribution of light in the four corners of the distributing end. Thus, a spectral composition of light may be different at different corners. For instance, the waveguide may be configured to separate light based on a wavelength crossing point, such that the light propagating unit preferentially provides light having a wavelength below the wavelength crossing point at two corners arranged diagonally in relation to each other and preferentially provides light having a wavelength above the wavelength crossing point at the two other corners.

For instance, the wavelength crossing point may be set in an interval of 480-580 nm, such as approximately 530 nm. The electric signals generated by the light sensitive elements associated with different corners for which light below or above the wavelength crossing point is preferentially detected may then be considered to represent blue and red light, respectively.

The waveguide may be configured to provide propagation of light according to a transverse electromagnetic (1,1) optical mode. This may facilitate providing a spatial distribution of light at the distributing end, wherein light of different wavelength bands is concentrated at the corners of the distributing end.

According to an embodiment of the second aspect, each light sensitive element is configured to receive light from at least two light propagating units.

This may imply that size of the light sensitive elements need not be very small. Hence, the manufacturing of the detector may not require light sensitive elements to be formed with a very small pitch, which may imply that the detector may not be very difficult to manufacture.

However, according to an alternative, the light sensitive elements are uniquely associated with a single light propagating unit such that each light sensitive element only receives light from a single light propagating unit.

The light propagating units may be arranged such that the two (or more) light propagating units providing light to the same light sensitive element may be configured to provide light of a similar or identical spectral content to the light sensitive element. The electric signal generated by the light sensitive element may thus be considered to represent light of a particular wavelength band, such as red or blue.

According to an embodiment of the first or the second aspect, the funnel element is asymmetrically arranged in relation to the waveguide such that a central funnel axis at the transmitting end is displaced from a central waveguide axis at the receiving end.

Thus, light may be asymmetrically coupled into the waveguide, i.e., light is not input into the waveguide symmetrically around the central waveguide axis at the receiving end. This may facilitate propagation of light in the waveguide such that a spatial distribution of the light at the distributing end is dependent on wavelength of the light.

The central funnel axis may correspond to an axis extending from the collecting end to the transmitting end of the funnel element, wherein the axis extends through a central position of each cross-section of the funnel element. Similarly, the central waveguide axis may correspond to an axis extending from the receiving end to the distributing end of the waveguide, wherein the axis extends through a central position of each cross-section of the waveguide.

The central funnel axis may be parallel to the central waveguide axis and both axes may extend substantially perpendicular to the plane of the light sensitive elements.

The funnel element may be arranged in contact with the waveguide. In such case, the position of the central funnel axis at the transmitting end corresponds to the position of the central funnel axis at the receiving end of the waveguide. However, if the funnel element is not in direct contact with the waveguide, the central funnel axis being displaced from the central waveguide axis at the receiving end implies that a projection of the central funnel axis along a direction of the central funnel axis onto the receiving end of the waveguide does not coincide with the central waveguide axis at the receiving end.

According to an embodiment of the first or second aspect, the funnel element has a rectangular shape at the collecting end, wherein a side of the funnel element is rotated in relation to a direction along a row of light sensitive elements by an angle in a range of 20-45°, such as in a range of 40-45°.

The angle between the row of the light sensitive elements and the side of the funnel element is defined in relation to the side of the funnel element for which a smallest angle is provided.

The arrangement of the funnel elements to be rotated in relation to a direction along the row of light sensitive elements allows the collecting ends of the funnel elements to be arranged to a very large extent to fill a plane onto which the light is incident.

For instance, the funnel element may have a square shape. Further, the angle may preferably be 45°. This may ensure that a maximum filling by the funnel elements of the plane into which the light is incident may be provided.

However, it should be realized that the funnel element are not necessarily rotated. Rather, the funnel element may be arranged with a rectangular shape wherein the sides of the funnel element are parallel with a row of light sensitive elements and a column of light sensitive elements, respectively. This may however imply that the funnel elements may not be arranged to fill the plane into which light is incident.

According to an embodiment of the first or second aspect, a height of the waveguide between the receiving end and the distributing end is in a range of 1-10 µm.

Since the height of the waveguide may be fairly large, arranging of the waveguides according to the first or second aspect for avoiding bow and warp of the semiconductor substate is especially important.

According to a third aspect, there is provided a semiconductor wafer structure, comprising: a plurality of groups of light propagating units associated with a plurality of imaging devices according to any one of the first or second aspects, wherein the plurality of groups of light propagating units is formed on a common substrate of the semiconductor wafer structure.

Effects and features of the third aspect are largely analogous to those described above in connection with the first and second aspects. Embodiments mentioned in relation to the first and second aspects are largely compatible with the third aspect.

Thus, a plurality of groups of light propagating units may be manufactured in parallel on a semiconductor wafer. The semiconductor wafer may be diced for providing separate groups of light propagating units.

The groups of light propagating units may be formed directly on the semiconductor substrate of the imaging devices. Thus, the semiconductor substrate of each of the imaging devices may be formed by the common substrate of the semiconductor wafer structure. However, according to an alternative, the groups of light propagating units may be formed on a separate carrier substrate. Thus, the semiconductor wafer on which the groups of light propagating units are formed may be diced into separate parts each providing a group of light propagating units for a single imaging device and thereafter the group of light propagating units may be bonded to the semiconductor substrate of the imaging device.

The arranging of the waveguides according to the first or second aspect is particularly advantageous when a plurality of imaging devices is manufactured on a large semiconductor wafer for avoiding bow and warp of the semiconductor wafer.

According to a fourth aspect, there is provided a method for wavelength dependent imaging, said method comprising: collecting, by a plurality of light propagating unis, light incident at a collecting end of a respective light collecting element of each light propagating unit of the plurality of light propagating units; propagating, for each light propagating unit, the light to a transmitting end of the light collecting element; receiving, at a receiving end of a waveguide of each light propagating unit, the light from the transmitting end; propagating, for each light propagating unit, the light to a distributing end of the waveguide, wherein the waveguide is a multimode waveguide, and wherein the propagating the light through the waveguide is dependent on wavelength such that a spatial distribution of the light at the distributing end is dependent on wavelength of the light; wherein (i) the waveguide has a cross-section parallel to the first surface, wherein the cross-section has an elongate shape defining a first size of the cross-section in a first direction and a second size of the cross-section in a second direction perpendicular to the first direction, wherein the first size is larger than the second size, and the waveguides of the plurality of light propagating units are arranged with different orientations such that a first waveguide of a first light propagating unit is rotated in relation to a second waveguide of a second light propagating unit defining an angle between the first direction of the first light propagating unit and the first direction of the second light propagating unit or (ii) the light collecting element is a funnel element, wherein a cross-section of the collecting end is larger than a cross-section of the transmitting end, and wherein each waveguide of the plurality of light propagating units has a cross-section parallel to the first surface, wherein the cross-section has a symmetrical shape defining a first size of the cross-section in a first direction and a second size of the cross-section in a second direction perpendicular to the first direction, wherein the first size is equal to the second size; and detecting, for each light propagating unit, the light at the distributing end, by at least two light sensitive elements of a plurality of light sensitive elements, such that each light sensitive element generates an electric signal dependent on an intensity of light incident onto the light sensitive element.

Effects and features of the fourth aspect are largely analogous to those described above in connection with the first, second, and third aspects. Embodiments mentioned in relation to the first, second, and third aspects are largely compatible with the fourth aspect.

The method provides imaging wherein light of different wavelengths are separated based on propagation of light in waveguides. Thus, the imaging is provided without discarding incident light to any large extent (e.g., by spectral filters), such that the method allows imaging with spectral resolution and with a high sensitivity to incident light.

Further, the method provides the imaging using an imaging device for which a risk of bow and warp of a substrate during manufacturing of the imaging device is avoided or reduced.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1a is a schematic perspective view of a light propagating unit and light sensitive elements that may be used in an imaging device.
Fig. 1b is a cross-sectional view taken along line A-A in Fig. 1a.
Fig. 2a is a schematic top view illustrating an imaging device according to a first embodiment comprising a plurality of light propagating units.
Fig. 2b is a perspective view of the plurality of light propagating units.
Fig. 3 is a schematic top view of the imaging device according to the first embodiment illustrating a first layout.
Fig. 4 is a schematic top view of the imaging device according to the first embodiment illustrating a second layout.
Fig. 5 is a schematic top view of the imaging device according to the first embodiment illustrating a third layout.
Fig. 6 is a schematic top view of the imaging device according to the first embodiment illustrating a fourth layout.
Fig. 7 is a schematic top view of the imaging device according to the first embodiment illustrating a fifth layout.
Fig. 8 is a schematic top view of the imaging device according to the first embodiment illustrating a sixth layout.
Fig. 9 is a schematic perspective view of a light propagating unit of an imaging device according to a second embodiment.
Fig. 10 is a cross-section at a distributing end of the light propagating unit illustrating distribution of light in dependence of wavelength.
Fig. 11 is a schematic top view of the imaging device of the second embodiment.
Fig. 12 is a schematic view of a semiconductor wafer carrying a plurality of imaging devices.
Fig. 13 is a flow chart of a method according to an embodiment.

### Detailed description

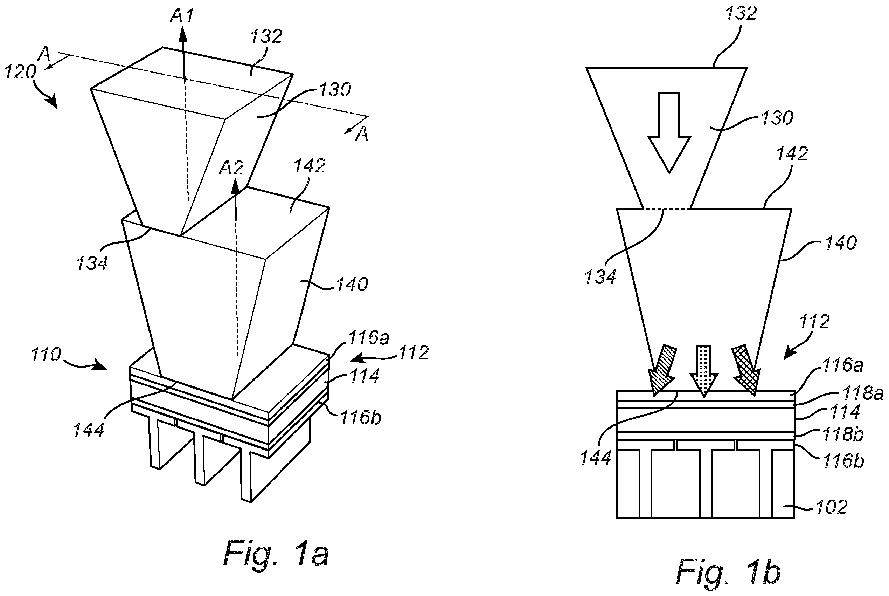

Referring now Figs 1a-b, a light propagating unit 120 which may be used in an imaging device for wavelength dependent imaging will initially be described. Fig. 1a shows a perspective view of the light propagating unit 120, while Fig. 1b shows a cross-sectional view along line A-A.

The light propagating unit 120 is configured to provide spectrally resolved imaging without using spectral filters. Thus, the light propagating unit 120 provides propagation of light in dependence of wavelength such that the light propagating unit 120 outputs a spatial distribution of light that is dependent on the wavelength of light.

As shown in Figs 1a-b, the light propagating unit 120 comprises a light collecting element in form of a funnel element 130. The funnel element 130 has a collecting end 132 and an opposite transmitting end 134. Each funnel element 130 defines a central funnel axis A1 extending from the collecting end 132 to the transmitting end 134.

The funnel element 130 is configured to collect light incident at the collecting end 132. The light may come from a scene being imaged by an objective lens (not shown here) onto the planar surface of the collecting end 132, however also other arrangements directing light onto the collecting end 132 are conceivable.

The funnel element 130 is further configured to propagate the light from the collecting end 132 to the transmitting end 134. As illustrated in Figs 1a-b, the funnel element 130 is tapered such that the cross-section of the collecting end 132 is larger than the cross-section of the transmitting end 134.

The light propagating unit 120 further comprises a waveguide 140 having a receiving end 142 and an opposite distributing end 144. The waveguide 140 defines a central waveguide axis A2 extending from the receiving end 142 to the distributing end 144. The waveguide 140 is arranged such that the receiving end 142 is facing the transmitting end 134 of the funnel element 130. The waveguide 140 may be arranged such that the receiving end 142 is in direct contact with the transmitting end 134 of the funnel element 130. Alternatively, the waveguide 140 may be arranged such that a gap is formed between the receiving end 142 and the transmitting end 134.

The waveguide 140 is configured to receive the light from the transmitting end 134 at the receiving end 142. Most of the light, and preferably all the light, collected at the collecting end 132 of the funnel element 130 may be propagated to the transmitting end 134 and coupled into the waveguide 140 via the receiving end 142.

Optionally, one or more additional layers may be provided between transmitting end 134 and the receiving end 142. The one or more additional layers may enhance the coupling of light between the funnel element 130 and the waveguide 140.

The funnel element 130 and the waveguide 140 are asymmetrically coupled. More specifically, the transmitting end 134 is coupled to the receiving end 142 such that the central funnel axis A1 at the transmitting end 134 is displaced with respect to the central waveguide axis A2 at the receiving end 142.

The waveguide 140 is further configured to propagate the light to the distributing end 144. The waveguide 140 is a multimode waveguide configured to propagate the light through the waveguide 140 in dependence of wavelength. By the present arrangement the spatial distribution of the light at the distributing end 144 is dependent on wavelength of the light. At the distributing end 144 the light may exit the waveguide 140.

The light propagating unit 120 may further be associated with a plurality of light sensitive elements 112, which may form part of an array of light sensitive elements 112. The light sensitive elements 112 are arranged in a planar fashion in a detector plane.

The light propagating unit 120 is arranged with respect to the light sensitive elements 112 such that the distributing end 144 is facing the array of light sensitive elements 112. More specifically, the light propagating unit 120 is arranged such that the distributing end 144 is facing at least two light sensitive elements 112. Thus, the light exiting the waveguide 140 at the distributing end 144 is incident onto the two light sensitive elements 112 of the array of light sensitive elements 112.

The distribution of the light at the distributing end 144 is dependent on wavelength of the received light. By way of example, the wavelengths of the light may be distributed by increasing wavelength from one edge of the distributing end 144 to an opposite edge of the distributing end 144, across the light sensitive elements 112 associated with the light propagating unit 120. However, also other types of distributions based on wavelength are conceivable. For instance, the light propagating unit 120 may be configured to preferentially propagate light to different parts of the distributing end 144, in dependence of the wavelength of light being above or below a wavelength crossing point. Thus, light having a wavelength above the wavelength crossing point may be mainly provided in a region close to one edge of the distributing end 144 and light having a wavelength below the wavelength crossing point may be mainly provided in a region close to the opposite edge of the distributing end 144.

Each light sensitive element 112 is configured to generate an electric signal which is dependent on an intensity of the light incident onto the light sensitive element 112. Thus, the array of light sensitive elements 112 may form part of a detector 110, which may be an image detector using charge-coupled devices (CCD) or complementary metal oxide semiconductors (CMOS). However, the detector 110 may alternatively be of another type.

As shown in Figs 1a-b, the light sensitive elements 112 may comprise a photoactive layer 114, which may be configured to generate an electric signal dependent on the intensity of light onto the photoactive layer 114. The photoactive layer 114 may further be arranged between electrodes 116a, 116b. Charge transport layers 118a, 118b may also be provided on opposite sides of the photoactive layer 114 between respective electrodes 116a, 116b and the photoactive layer 114. The light sensitive elements 112 may hence be formed as a thin film photodetector.

The photoactive layer 114 may be configured to generate charges in dependence of incident light. The generated charges may form the electric signal at the electrode 116b being arranged farthest away from the waveguide 140, i.e., the photoactive layer 114 is arranged between the waveguide and the electrode 116b.

The electrode 116b may be formed in or integrated on a first surface of a semiconductor substrate 102. The semiconductor substrate 102 may further comprise read-out circuitry for reading out the electric signals from the light sensitive elements 112 and possibly further processing the read out electric signals.

Further, the detector 110 comprising the light sensitive elements 112 may be integrated on the first surface. The thin film layers may be deposited on the semiconductor substrate 102 so as to be integrated with the semiconductor substrate 102.

Further, the light propagating unit 120 may be integrated on the light sensitive elements 112. Thus, the light propagating unit 120 and the light sensitive elements 112 may be formed in a compact manner and may be manufactured using techniques for processing layers on a semiconductor surface.

The height of the waveguide 140 between the receiving end 142 and the distributing end 144 may for instance be in a range of 1-10 µm. This implies that a relatively thick waveguide layer, in which the waveguide 140 is formed, need to be integrated on the semiconductor substrate 102.

The waveguide 140 has a cross-section parallel to the first surface of the semiconductor substrate 102. The cross-section has an elongate shape defining a first size of the cross-section in a first direction and a second size of the cross-section in a second direction perpendicular to the first direction. The first size is larger than the second size.

As shown in Fig. 1a, the cross-section of the waveguide may be rectangular. However, it should be realized that other shapes may be conceivable, such as an elliptic shape. In addition, it should be realized that in manufacturing of the waveguide 140, the cross-section of the waveguide 140 may not be perfectly rectangular but rather the edges may not be perfectly sharp.

The light propagating unit 120 may form part of an imaging device, wherein a plurality of light propagating units is formed in an array. In addition, during manufacturing of at least the light propagating units 120 of the imaging device, the light propagating units 120 may be formed on a semiconductor wafer carrying a plurality of groups of light propagating units to be associated with a plurality of different imaging devices. These groups of light propagating units may later be formed into separate parts for separate imaging devices by dicing of the semiconductor wafer.

Thus, a large number of light propagating units 120 may be formed in a relatively thick waveguide layer on the semiconductor wafer. If the waveguides of the light propagating units are aligned such that the first directions of all of the light propagating units are formed along parallel lines on the semiconductor wafer, a high mechanical stress in the waveguide layer may be formed. This may cause bow or warp of the semiconductor wafer or even form cracks in the semiconductor wafer.

Bow or warp may imply that the semiconductor wafer is deformed so as not to maintain its flatness. After forming of the waveguide layer, the funnel elements 130 are to be formed with an accurate relation to the waveguide 140. Thus, if bow or warp of the semiconductor wafer occurs, accurate placement of the funnel elements 130 on waveguides 140 may be difficult or impossible to achieve.

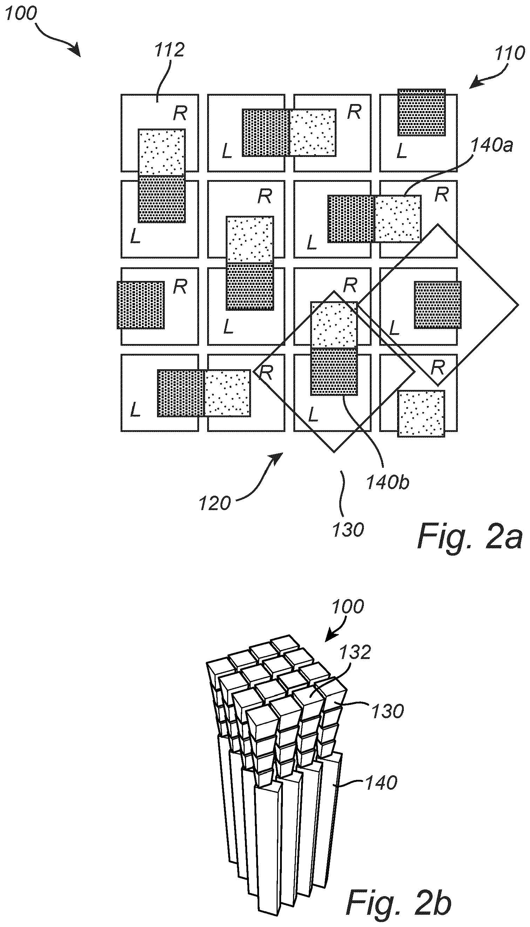

Referring now to Fig. 2a, an arrangement of a plurality of light propagating units 120 will be discussed. The plurality of light propagating units 120 are part of an imaging device 100 for wavelength dependent imaging according to a first embodiment.

Fig. 2a shows a top view of the imaging device 100. The imaging device 100 comprises a detector 110 comprising an array of light sensitive elements 112 as described above. The imaging device 100 further comprises a plurality of light propagating units 120 as described above.

As shown in Fig. 2a, the light sensitive elements 112 are arranged in an array along rows and columns. The light propagating units 120 are arranged with different orientations of the waveguides 140a, 140b on the first surface of the semiconductor substrate 102. Hence, waveguides 140a, 140b of different orientations define an angle between the first directions of the waveguides 140a, 140b. This implies that material anisotropy in the waveguide layer may be reduced. Hence, mechanical stress in the waveguide layer may be avoided such that bow or warp of the semiconductor wafer may be avoided during manufacturing of the imaging device 100.

As shown in Fig. 2a, the waveguides 140a, 140b may be aligned with a row or a column of the array of light sensitive elements 112. Thus, the plurality of light propagating units 120 comprises a first set of light propagating units and a second set of light propagating units. The waveguides 140a of the light propagating units of the first set are arranged with a first orientation, wherein the first direction of the elongate shape is aligned with a direction of a row of the light sensitive elements 112. The waveguides 140b of the light propagating units of the second set are arranged with a second orientation, wherein the first direction of the elongate shape is aligned with a direction of a column of the light sensitive elements 112. The light propagating units of the first set are intermixed with the light propagating units of the second set on the semiconductor substrate 102.

As shown in Fig. 2a, the light propagating units are arranged such that along a row of the light sensitive elements 112, light propagating units of the first and second sets are alternatingly arranged. In Fig. 2a, all light propagating units 120 are identical so as to provide the same separation of wavelengths of light at the distributing end 144. Here, each light propagating unit 120 is associated with two light sensitive elements 112 along a straight line (a row or a column, respectively). Thus, the two light sensitive elements 112 may receive different spectral content of light such that the electric signals generated by the light sensitive elements 112 may be considered to represent different wavelengths of light (here represented by L (left) and R (right)). Thus, the imaging device 100 provides imaging with spatial and spectral resolution.

Fig. 2a further indicates the collecting ends of two funnel elements 130 of the light propagating units 120. The funnel element 130 has a square shape at the collecting end 132. The funnel element 130 is rotated in relation to a direction along a row of the light sensitive elements 112 such that a side of the funnel element 130 defines an angle in relation to the direction along the row. As shown, the funnel element 130 may be rotated by 45° to the direction along the row. As further illustrated by the two funnel elements 130 shown in Fig. 2a, this implies that the collecting ends 132 of the funnel elements 130 may be large so as to fill a plane formed by the collecting ends 132.

Hence, the collecting ends 132 of the plurality of light propagating units 120 are arranged adjacent to each other leaving only small gaps, or no gaps, in between the different collecting ends 132. In the present arrangement, the collecting ends 132 of the funnel elements 130 are arranged in a common plane parallel to the detector plane. For each light propagating unit 120, the central funnel axis A1 is arranged to be perpendicular to the detector plane.

Fig. 2b shows a perspective view of a plurality of light propagating units 120 illustrating arrangement of funnel elements 130 in relation to waveguides 140.

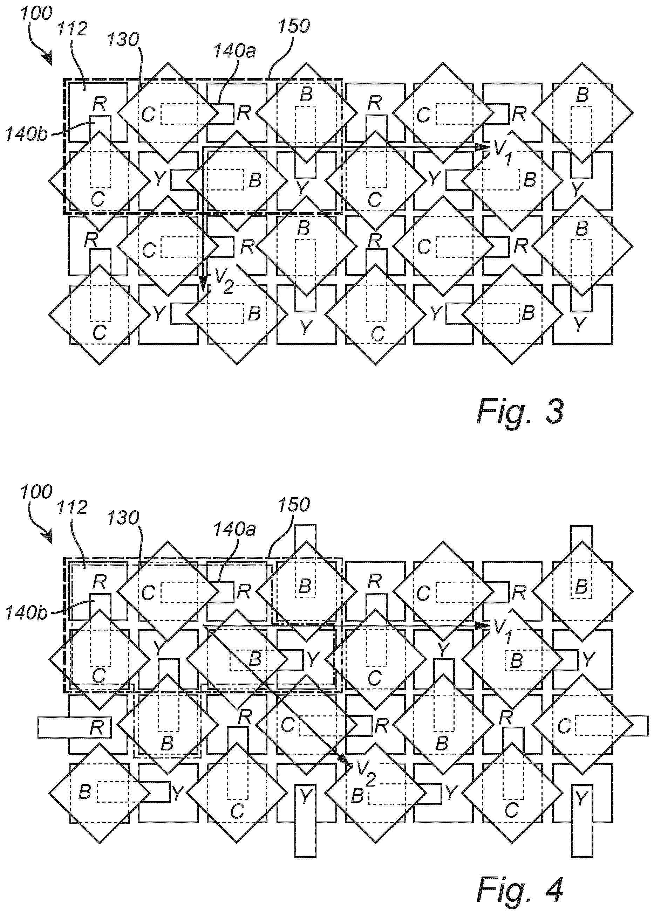

Referring now to Figs 3-8, different layouts of the imaging device 100 will be described. These layouts have in common that the plurality of light propagating units 120 comprise a first set of light propagating units and second set of light propagating units, wherein the waveguides 140a of the light propagating units 120 in the first set are aligned with rows of the light sensitive elements 112 and the waveguides 140b of the light propagating units 120 in the second set are aligned with columns of the light sensitive elements 112.

The plurality of light propagating units further comprises a first type of light propagating unit and a second type of light propagating unit.

The first type of light propagating unit is configured to separate light in relation to a wavelength crossing point in an interval of 560-600 nm, such as approximately 580 nm. This implies that the first type of light propagating units may provide light in a wavelength above 580 nm to a first light sensitive element and light in a wavelength below 580 nm to a second light sensitive element. The light detected by these light sensitive elements may be considered to represent red light (denoted by R in Figs 3-8) and a relatively broad wavelength range including blue, cyan, and green light (denoted by C for cyan in Figs 3-8). These light sensitive elements may be referred to as red pixels and cyan pixels, respectively.

The second type of light propagating unit is configured to separate light in relation to a wavelength crossing point in an interval of 460-500 nm, such as approximately 480 nm. This implies that the second type of light propagating units may provide light in a wavelength above 480 nm to a first light sensitive element and light in a wavelength below 480 nm to a second light sensitive element. The light detected by these light sensitive elements may be considered to represent blue light (denoted by B in Figs 3-8) and a relatively broad wavelength range including green, yellow, and red light (denoted by Y for yellow in Figs 3-8). These light sensitive elements may be referred to as blue pixels and yellow pixels, respectively.

The use of the first and second types of light propagating units may allow acquiring of an image with improved spectral resolution. The plurality of light sensitive elements 112 and the plurality of light propagating units 120 are arranged in unit cells 150 that are repeated across the first surface of the semiconductor substrate 102. Each unit cell 150 may correspond to a single image point in the image acquired by the imaging device 100, wherein the separation of light in dependence of wavelength provides spectral resolution for each image point. Further, the unit cells 150 being repeated provide spatial resolution of imaging by the imaging device 100.

Each unit cell 150 includes an equal number of light propagating units 120 belonging to the first set and light propagating units 120 belonging to the second set. Each unit cell 150 further includes light propagating units of the first and second types for providing spectral resolution.

Fig. 3 shows a first layout of the light propagating units 120. As shown in Fig. 3, along a pair of rows, two light propagating units 120 extending along parallel columns are followed by two light propagating units 120 extending along the rows of the pair. Thus, the first layout provides a unit cell 150 having a rectangular shape.

Each unit cell 150 comprises two light propagating units of the first type, one of which belongs to the first set with the waveguide 140a oriented along a row, and the other of which belongs to the second set with the waveguide 140b oriented along a column. The unit cell 150 also comprises two light propagating units of the second type, one of which belongs to the first set with the waveguide oriented along a row, and the other of which belongs to the second set with the waveguide oriented along a column.

The unit cells 150 are repeated such that unit vectors V1, V2 extending from a center of a unit cell to centers of adjacent unit cells are parallel with the rows and columns, respectively, and hence perpendicular to each other.

The funnel elements 130 are rotated in relation to the rows and columns. The funnel elements 130 are arranged to be asymmetrically coupled to the waveguides 140 such that the funnel elements 130 are coupled to waveguides 140 above a light sensitive element that will detect cyan light for light propagating units of the first type and coupled to waveguides above a light sensitive element that will detect blue light for light propagating units of the second type.

Fig. 4 shows a second layout of the light propagating units 120. In the second layout, adjacent waveguides extending along neighboring columns are displaced in relation to each other so as not to be associated with the same rows. This implies that the waveguides may not be arranged in as orderly fashion as in the first layout. However, this may also imply that the imaging device 100 may be more stable and even less prone to bow or warp in manufacturing than the imaging device according to the first layout.

As illustrated in dash-dotted line in Fig. 4, a unit cell may be defined having a shape corresponding to two L-shapes being arranged next to each other with long legs of the L-shapes being parallel and short legs of the L-shapes being parallel. One of the L-shapes comprises two light propagating units of the first type, one of which belongs to the first set with the waveguide 140a oriented along a row, and the other of which belongs to the second set with the waveguide 140b oriented along a column. The other of the L-shapes comprises two light propagating units of the second type, one of which belongs to the first set with the waveguide oriented along a row, and the other of which belongs to the second set with the waveguide oriented along a column.

However, as further shown in Fig. 4, the unit cell 150 may have a rectangular shape. Each unit cell 150 thus comprises two light propagating units of the first type, one of which belongs to the first set with the waveguide 140a oriented along a row, and the other of which belongs to the second set with the waveguide 140b oriented along a column. The unit cell 150 also comprises four light sensitive elements 112 associated with light propagating units of the second type. These light propagating units of the second type are arranged such that one light propagating unit belonging to the first set with the waveguide oriented along a row is included in the unit cell 150. Further, two light sensitive elements 112 associated with different light propagating units of the second type belonging to the second set with the waveguide oriented along a column are included in the unit cell 150.

The unit cells 150 are repeated such that unit vectors V1, V2 extending from a center of a unit cell to centers of adjacent unit cells extend parallel with the rows and at a 45° angle to the columns, respectively.

The funnel elements 130 are rotated in relation to the rows and columns in a similar way as discussed above for the first layout.

The second layout is formed by providing light propagating units to be oriented such that the light propagating units of the first type being arranged along a row provide a cyan pixel to the left of a red pixel and light propagating units of the first type being arranged along a column provide a red pixel above a cyan pixel. Further, the light propagating units of the second type arranged along a row provide a blue pixel to the left of a yellow pixel and light propagating units of the second type arranged along a column provide a yellow pixel above a blue pixel.

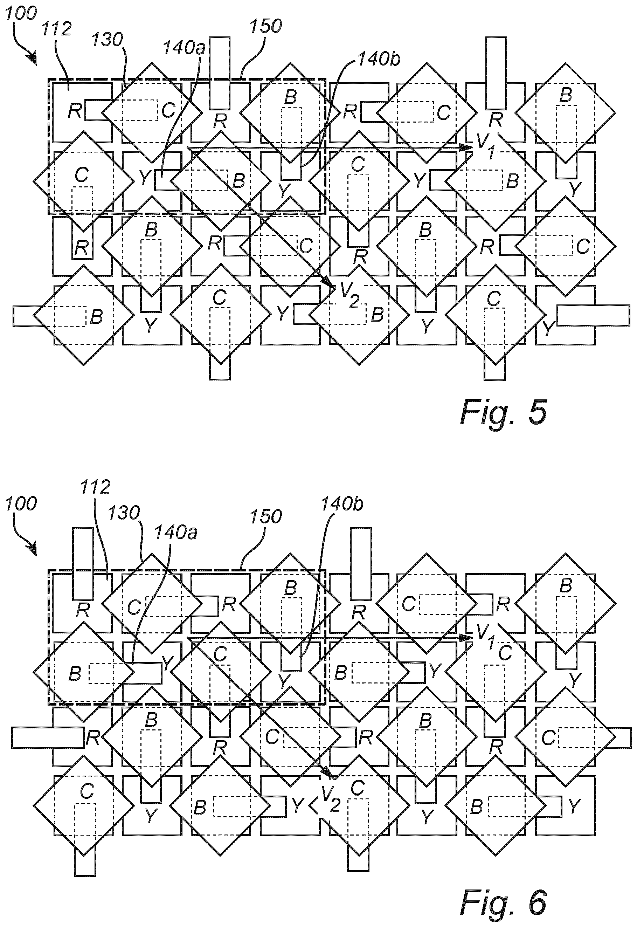

Fig. 5 shows a third layout of the light propagating units 120. In the third layout, like the second layout, adjacent waveguides extending along neighboring columns are displaced in relation to each other so as not to be associated with the same rows.

Here, the light propagating units are oriented such that the light propagating units of the first type being arranged along a row provide a red pixel to the left of a cyan pixel and light propagating units of the first type being arranged along a column provide a cyan pixel above a red pixel. Further, the light propagating units of the second type arranged along a row provide a yellow pixel to the left of a blue pixel and light propagating units of the second type arranged along a column provide a blue pixel above a yellow pixel.

As shown in Fig. 5, the unit cell 150 may have a rectangular shape. Here, each unit cell 150 comprises two light propagating units of the second type, one of which belongs to the first set with the waveguide 140a oriented along a row, and the other of which belongs to the second set with the waveguide 140b oriented along a column. The unit cell 150 also comprises four light sensitive elements 112 associated with light propagating units of the first type. These light propagating units of the first type are arranged such that one light propagating unit belonging to the first set with the waveguide oriented along a row is included in the unit cell 150. Further, two light sensitive elements 112 associated with different light propagating units of the first type belonging to the second set with the waveguide oriented along a column are included in the unit cell 150.

The unit cells 150 are repeated such that unit vectors V1, V2 extending from a center of a unit cell to centers of adjacent unit cells extend parallel with the rows and at a 45° angle to the columns, respectively.

The funnel elements 130 are rotated in relation to the rows and columns in a similar way as discussed above for the first layout.

Fig. 6 shows a fourth layout of the light propagating units 120. In the fourth layout, like the second and third layouts, adjacent waveguides extending along neighboring columns are displaced in relation to each other so as not to be associated with the same rows.

Here, the light propagating units are oriented such that the light propagating units of the first type being arranged along a row provide a cyan pixel to the left of a red pixel and light propagating units of the first type being arranged along a column provide a cyan pixel above a red pixel. Further, the light propagating units of the second type arranged along a row provide a blue pixel to the left of a yellow pixel and light propagating units of the second type arranged along a column provide a blue pixel above a yellow pixel.

As shown in Fig. 6, the unit cell 150 may have a rectangular shape. Here, each unit cell 150 comprises two light propagating units of the second type, one of which belongs to the first set with the waveguide 140a oriented along a row, and the other of which belongs to the second set with the waveguide 140b oriented along a column. The unit cell 150 also comprises four light sensitive elements 112 associated with light propagating units of the first type. These light propagating units of the first type are arranged such that one light propagating unit belonging to the first set with the waveguide oriented along a row is included in the unit cell 150. Further, two light sensitive elements 112 associated with different light propagating units of the first type belonging to the second set with the waveguide oriented along a column are included in the unit cell 150.

The unit cells 150 are repeated such that unit vectors V1, V2 extending from a center of a unit cell to centers of adjacent unit cells extend parallel with the rows and at a 45° angle to the columns, respectively.

The funnel elements 130 are rotated in relation to the rows and columns in a similar way as discussed above for the first layout.

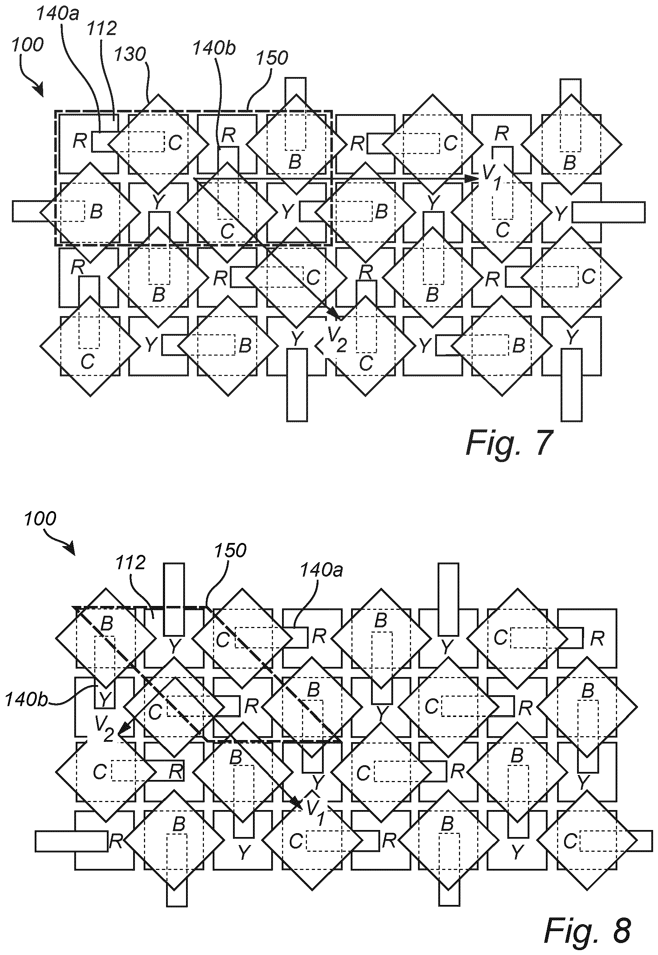

Fig. 7 shows a fifth layout of the light propagating units 120. In the fifth layout, like the second, third, and fourth layouts, adjacent waveguides extending along neighboring columns are displaced in relation to each other so as not to be associated with the same rows.

Here, the light propagating units are oriented such that the light propagating units of the first type being arranged along a row provide a red pixel to the left of a cyan pixel and light propagating units of the first type being arranged along a column provide a red pixel above a cyan pixel. Further, the light propagating units of the second type arranged along a row provide a yellow pixel to the left of a blue pixel and light propagating units of the second type arranged along a column provide a yellow pixel above a blue pixel.

As shown in Fig. 7, the unit cell 150 may have a rectangular shape. Here, each unit cell 150 comprises two light propagating units of the first type, one of which belongs to the first set with the waveguide 140a oriented along a row, and the other of which belongs to the second set with the waveguide 140b oriented along a column. The unit cell 150 also comprises four light sensitive elements 112 associated with light propagating units of the first type. These light propagating units of the first type are arranged such that four light sensitive elements 112 included in the unit cell 150 are each associated with different light propagating units of the second type. Two of these light propagating units of the second type belong to the first set with the waveguide oriented along a row and two of the light propagating units of the second type belong to the second set with the waveguide oriented along a column.

The unit cells 150 are repeated such that unit vectors V1, V2 extending from a center of a unit cell to centers of adjacent unit cells extend parallel with the rows and at a 45° angle to the columns, respectively.

The funnel elements 130 are rotated in relation to the rows and columns in a similar way as discussed above for the first layout.

Fig. 8 shows a sixth layout of the light propagating units 120. In the sixth layout, like the second, third, fourth, and fifth layouts, adjacent waveguides extending along neighboring columns are displaced in relation to each other so as not to be associated with the same rows.

In the sixth layout, all of the light propagating units of the first type are arranged with the waveguides 140a arranged along rows of the light sensitive elements 112. Hence, the light propagating units of the first type belong to the first set of light propagating units. Further, all of the light propagating units of the second type are arranged with the waveguides 140b arranged along columns of the light sensitive elements 112. Hence, the light propagating units of the second type belong to the second set of light propagating units.

Here, a unit cell 150 having a shape of a parallelogram may be defined. The unit cell 150 may thus be defined across light sensitive elements 112 such that some light sensitive elements 112 belong partly to different unit cells 150.

Each unit cell 150 may thus comprise a full light sensitive element 112 providing a red pixel, a full light sensitive element 112 providing a yellow pixel, two halves of different light sensitive elements 112 providing cyan pixels, and two halves of different light sensitive elements 112 providing blue pixels.

The unit cells 150 are repeated such that unit vectors V1, V2 extending from a center of a unit cell to centers of adjacent unit cells extend in two different diagonal directions in relation to the rows and columns such that the unit vectors are perpendicular to each other.

The funnel elements 130 are rotated in relation to the rows and columns in a similar way as discussed above for the first layout.

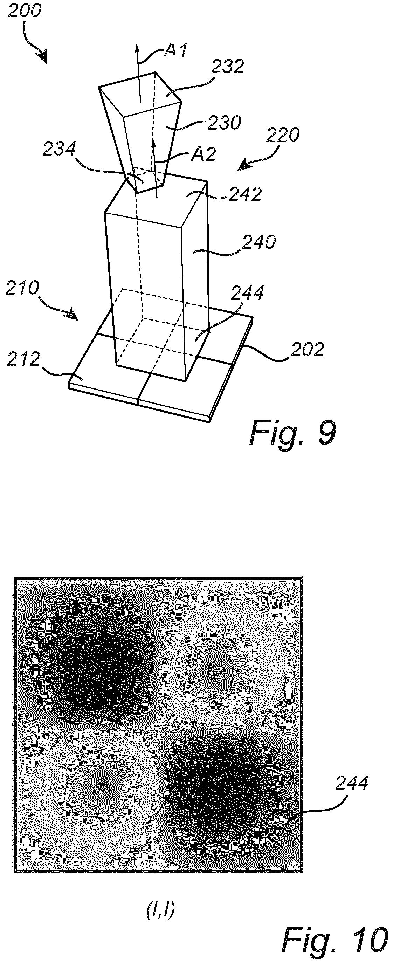

Referring now to Fig. 9, a light propagating unit 220 according to an imaging device 200 of a second embodiment will be discussed. The imaging device 200 is similar to the imaging device 100 described above. For brevity and to avoid repetition, features in common are not described again for the second embodiment. In particular, the semiconductor substrate 202 and the detector 210 comprising a plurality of light sensitive elements 212 may be similar to the semiconductor substrate and the detector described above for the first embodiment.

The light propagating unit 220 of the imaging device 200 differs from the light propagating unit 220 in that the waveguide 240 of the light propagating unit 220 has a cross-section parallel to the first surface, wherein the cross-section has a symmetrical shape defining a first size of the cross-section in a first direction and a second size of the cross-section in a second direction perpendicular to the first direction, wherein the first size is equal to the second size.

This implies that the light propagating unit 220 has a shape such that material anisotropy in the waveguide layer is avoided. Hence, mechanical stress in the waveguide layer may be avoided such that bow or warp of the semiconductor wafer may be avoided during manufacturing of the imaging device 200.

The light propagating unit 220 comprises a funnel element 230 having a collecting end 132 and an opposite transmitting end 234. The funnel element 230 defines a central funnel axis A1 extending from the collecting end 232 to the transmitting end 234.

The funnel element 230 is configured to collect light incident at the collecting end 232 and to propagate the light to the transmitting end 234.

The light propagating unit 220 further comprises a waveguide 240 having a receiving end 242 and an opposite distributing end 244. The waveguide 240 defines a central waveguide axis A2 extending from the receiving end 242 to the distributing end 244. The waveguide 240 is arranged such that the receiving end 242 is facing the transmitting end 234 of the funnel element 230.

The waveguide 240 is configured to receive the light from the transmitting end 234 at the receiving end 242. Most of the light, and preferably all the light, collected at the collecting end 232 of the funnel element 230 may be propagated to the transmitting end 234 and coupled into the waveguide 240 via the receiving end 242.

The funnel element 230 and the waveguide 2are asymmetrically coupled. More specifically, the transmitting end 234 is coupled to the receiving end 242 such that the central funnel axis A1 at the transmitting end 234 is displaced with respect to the central waveguide axis A2 at the receiving end 142.

The waveguide 240 is further configured to propagate the light to the distributing end 244. The waveguide 240 is a multimode waveguide configured to propagate the light through the waveguide 240 in dependence of wavelength. By the present arrangement the spatial distribution of the light at the distributing end 244 is dependent on wavelength of the light. At the distributing end 244 the light may exit the waveguide 240.

As illustrated in Fig. 10, the waveguide 240 may be configured to provide propagation of light according to a transverse electromagnetic (1,1) optical mode. This may facilitate providing a spatial distribution of light at the distributing end 244, wherein light of different wavelength bands is preferentially propagated to different corners of the distributing end 244.

Thus, a spectral composition of light output by the light propagating unit 240 may be different at different corners of the distributing end 244. For instance, the waveguide may be configured to separate light based on a wavelength crossing point, such that the light propagating unit 240 preferentially provides light having a wavelength below the wavelength crossing point at two corners arranged diagonally in relation to each other and preferentially provides light having a wavelength above the wavelength crossing point at the two other corners.

For instance, the wavelength crossing point may be set in an interval of 480-580 nm, such as approximately 530 nm. The electric signals generated by the light sensitive elements associated with different corners for which light below or above the wavelength crossing point is preferentially detected may then be considered to represent blue and red light, respectively.

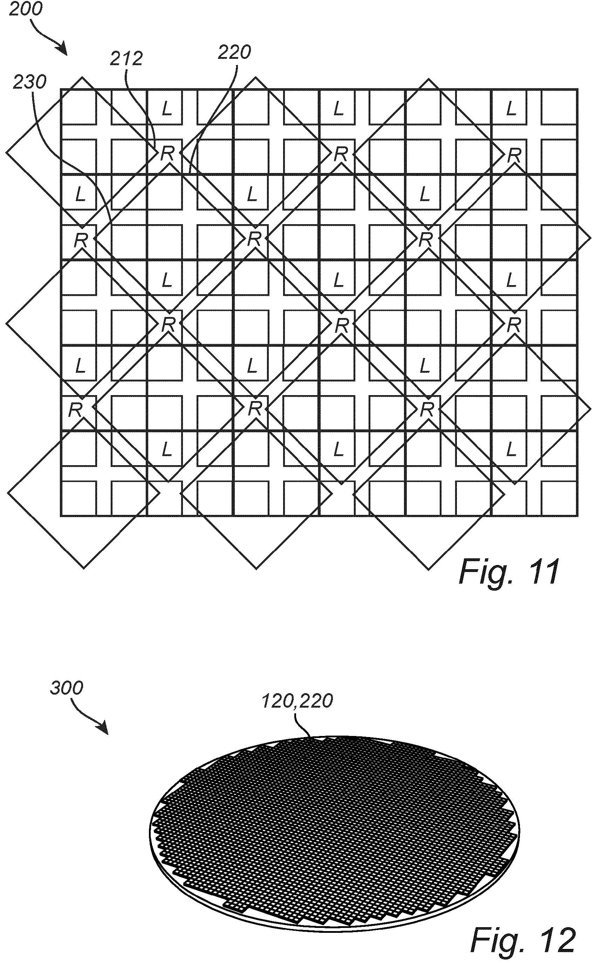

Referring now to Fig. 11, an arrangement of a plurality of light propagating units 220 of the imaging device 200 will be discussed.

Fig. 11 shows a top view of the imaging device 200, showing a detector 210 comprising an array of light sensitive elements 212 as described above. The imaging device 200 further comprises a plurality of light propagating units 220 as described above.

As shown in Fig. 11, the light sensitive elements 212 are arranged in an array along rows and columns. The light propagating units 220 are arranged with the first and second directions of the waveguide 220 parallel with the rows and columns of the array, respectively. The light propagating units 220 may be configured in relation to the light sensitive elements 212 such that the four corners of the distributing end 244 are each associated with a unique light sensitive element 212. Thus, the separation of the spectral information by the light propagation unit 220 provides different spectral composition of light to different light sensitive elements 212 for detecting the spectral information, indicated by light sensitive elements 212 denoted by L and R, respectively, in Fig. 11.

The distributing ends 244 of adjacent light propagating units 220 may be arranged such that corners of the light propagating units 220 are touching or close to each other. Thus, a diagonal in a cross-section of a distributing end 244 is collinear with the diagonal in the cross-section of the distributing end 244 of the adjacent light propagating unit 220. Two such diagonally aligned light propagating units 220 may be associated with the same light sensitive element 212, such that the light at the neighboring corners of the distributing ends 244 is output to the same light sensitive element 212.

Thus, the light sensitive element 212 may be configured to receive light from two light propagating units 240 so as to detect a combination of light from two light propagating units 240. However, the waveguides 240 are configured to separate light so as to provide the same or similar spectral content at the neighboring corners. Thus, the light sensitive element 212 may be configured to receive light in a particular wavelength band such that the light sensitive element 212 may form a blue or red pixel.

As shown in Figs 9 and 11, the funnel element 230 may be rotated in relation to a direction along a row of light sensitive elements 212, similar to the arrangement of the funnel elements in the imaging device of the first embodiment. The funnel element may be rotated by 45° to the direction along the row. As further illustrated by the funnel elements 230 shown in Fig. 11, this implies that the collecting ends 232 of the funnel elements 230 may be large so as to fill a plane formed by the collecting ends 232.

As mentioned above, a plurality of groups of light propagating units to be associated with a plurality of different imaging devices may be manufactured on a common semiconductor wafer 300, as illustrated in Fig. 12. The light propagating units 120, 220 according to any of the embodiments described above may be manufactured on the semiconductor wafer 300.

The semiconductor wafer 300 may provide the semiconductor substrate of the imaging devices. Further, the imaging devices may be formed in parallel on the semiconductor wafer 300. After the imaging devices have been fully formed on the semiconductor wafer 300, the semiconductor wafer 300 may be diced for providing separate devices.

Alternatively, the semiconductor wafer 300 may provide a carrier substrate for manufacturing of the light propagating units. The plurality of groups of light propagating units may be formed in parallel on the semiconductor wafer 300. After the groups of light propagating units have been fully formed on the semiconductor wafer 300, the semiconductor wafer 300 may be diced for providing separate groups of light propagating units to be bonded to separate semiconductor substrates forming part of different imaging devices.

Thanks to the imaging devices being configured so as to avoid material anisotropy in the waveguide layer, the plurality of imaging devices or the plurality of groups of light propagating units may be formed on the semiconductor wafer 300 with a low risk of bow or warp of the semiconductor wafer 300. This implies that the manufacturing of the imaging devices may be provided with high accuracy and with low risk of damages to the imaging devices during manufacturing. Hence, a high yield in manufacturing of the imaging devices may be provided.

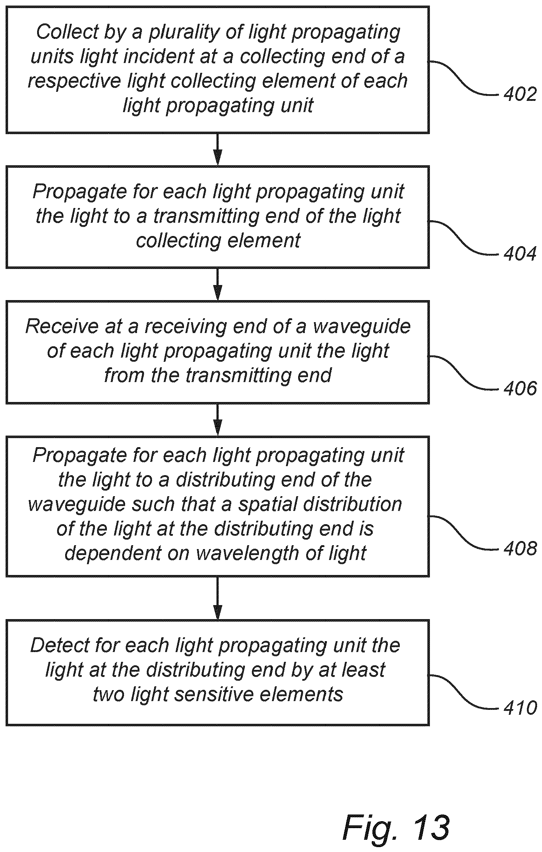

Referring now to Fig. 13, a method for wavelength dependent imaging will be described.

The method comprises collecting 402, by a plurality of light propagating unis, light incident at a collecting end of a respective light collecting element of each light propagating unit of the plurality of light propagating units. The light collecting elements may be arranged with small or no gaps between adjacent light collecting elements such that the light collecting elements, at least to a high extent, fill a plane formed by the collecting ends 132.

The method further comprises propagating 404, for each light propagating unit, the light to a transmitting end of the light collecting element. The light collecting elements may be funnel elements, wherein a cross-section of the collecting end is larger than a cross-section of the transmitting end.

The method further comprises receiving 406, at a receiving end of a waveguide of each light propagating unit, the light from the transmitting end. The light may be asymmetrically coupled from the transmitting end to the receiving end of the waveguide such that light entering the receiving end of the waveguide is not centered around a central waveguide axis.

The method further comprises propagating 408, for each light propagating unit, the light to a distributing end of the waveguide. The waveguide is a multimode waveguide, and wherein the propagating the light through the waveguide is dependent on wavelength such that a spatial distribution of the light at the distributing end is dependent on wavelength of the light.

Thus, the light propagating units provide a separation of light based on wavelength such that light belonging to different wavelength bands may be detected without need of filtering of light. This implies that light is not discarded in order to enable acquiring spectral information.

The method further comprises detecting 410, for each light propagating unit, the light at the distributing end, by at least two light sensitive elements of a plurality of light sensitive elements, such that each light sensitive element generates an electric signal dependent on an intensity of light incident onto the light sensitive element.

According to the first embodiment disclosed above, the waveguide may have a cross-section parallel to the first surface, wherein the cross-section has an elongate shape defining a first size of the cross-section in a first direction and a second size of the cross-section in a second direction perpendicular to the first direction, wherein the first size is larger than the second size, and the waveguides of the plurality of light propagating units are arranged with different orientations such that a first waveguide of a first light propagating unit is rotated in relation to a second waveguide of a second light propagating unit defining an angle between the first direction of the first light propagating unit and the first direction of the second light propagating unit.

According to the second embodiment disclosed above, each waveguide of the plurality of light propagating units has a cross-section parallel to the first surface, wherein the cross-section has a symmetrical shape defining a first size of the cross-section in a first direction and a second size of the cross-section in a second direction perpendicular to the first direction, wherein the first size is equal to the second size.

Both of the embodiments facilitate manufacturing of an imaging device that may be used for performing the method in that bow and warp of a semiconductor wafer may be avoided during manufacturing.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An imaging device (100) for wavelength dependent imaging, the imaging device (100) comprising:
a semiconductor substrate (102) comprising a first surface;
a detector (110) comprising a plurality of light sensitive elements (112) integrated with the first surface of the semiconductor substrate (102), wherein each light sensitive element (112) is configured to generate an electric signal dependent on an intensity of light incident onto the light sensitive element (112);
a plurality of light propagating units (120) arranged integrated on the first surface of the semiconductor substrate (102) above the plurality of light sensitive elements (112), wherein each light propagating unit (120) of the plurality of light propagating units comprises:
a light collecting element (130) having a collecting end (132) and a transmitting end (134), the light collecting element (130) being configured to collect light incident at the collecting end (132) and to propagate the light to the transmitting end (134);
a waveguide (140) having a receiving end (142) and a distributing end (144), the waveguide (140) being configured to receive the light from the transmitting end (134) at the receiving end (142) and to propagate the light to the distributing end (144), wherein the waveguide (140) is a multimode waveguide configured to propagate the light through the waveguide (140) in dependence of wavelength such that a spatial distribution of the light at the distributing end (144) is dependent on wavelength of the light;
wherein the waveguide (140) has a cross-section parallel to the first surface, wherein the cross-section has an elongate shape defining a first size of the cross-section in a first direction and a second size of the cross-section in a second direction perpendicular to the first direction, wherein the first size is larger than the second size;
wherein the waveguides (140) of the plurality of light propagating units (120) are arranged with different orientations on the first surface of the semiconductor substrate (102) such that a first waveguide of a first light propagating unit is rotated in relation to a second waveguide of a second light propagating unit defining an angle between the first direction of the first light propagating unit and the first direction of the second light propagating unit.

2. The imaging device according to claim 1, wherein the plurality of light propagating units comprises a first set of light propagating units and a second set of light propagating units, wherein the waveguides (140a) of the light propagating units of the first set are arranged with a first orientation, wherein the first direction of the elongate shape is aligned with a direction of a row of the light sensitive elements (112), wherein the waveguides (140b) of the light propagating units of the second set are arranged with a second orientation, wherein the first direction of the elongate shape is aligned with a direction of a column of the light sensitive elements (112), wherein the light propagating units of the first set are intermixed with the light propagating units of the second set on the semiconductor substrate (102).

3. The imaging device according to claim 2, wherein each light propagation unit (120) is associated with at least two light sensitive elements (112) arranged along a straight line, wherein the spatial distribution of the light at the distributing end (144) of the waveguide (140) is incident onto the at least two light sensitive elements (112).

4. The imaging device according to claim 2 or 3, wherein the plurality of light sensitive elements (112) and the plurality of light propagating units (120) are arranged in unit cells (150) that are repeated across the first surface of the semiconductor substrate (102), wherein each unit cell (150) includes an equal number of light propagating units belonging to the first set and light propagating units belonging to the second set.

5. The imaging device according to claim 4, wherein each unit cell (150) has a rectangular shape.

6. The imaging device according to claim 4, wherein each unit cell has a shape corresponding to two L-shapes being arranged next to each other with long legs of the L-shapes being parallel and short legs of the L-shapes being parallel.

7. The imaging device according to any one of claims 4-6, wherein the light detecting elements (112) of each unit cell (150) are configured to detect light in four different wavelength ranges of visible light for providing spatial and spectral resolution of imaging.

8. The imaging device according to any one of the preceding claims,
wherein the light collecting element is a funnel element, wherein a cross-section of the collecting end (132) is larger than a cross-section of the transmitting end (134).

9. An imaging device (200) for wavelength dependent imaging, the imaging device (100) comprising:
a semiconductor substrate (202) comprising a first surface;
a detector (210) comprising a plurality of light sensitive elements (212) integrated with the first surface of the semiconductor substrate (202), wherein each light sensitive element (212) is configured to generate an electric signal dependent on an intensity of light incident onto the light sensitive element (212);
a plurality of light propagating units (220) arranged integrated on the first surface of the semiconductor substrate (202) above the plurality of light sensitive elements (212), wherein each light propagating unit (220) of the plurality of light propagating units comprises:
a funnel element (230) having a collecting end (232) and a transmitting end (234), the funnel element (230) being configured to collect light incident at the collecting end (232) and to propagate the light to the transmitting end (234), wherein a cross-section of the collecting end (232) is larger than a cross-section of the transmitting end (234);
a waveguide (240) having a receiving end (242) and a distributing end (244), the waveguide (240) being configured to receive the light from the transmitting end (234) at the receiving end (242) and to propagate the light to the distributing end (244), wherein the waveguide (240) is a multimode waveguide configured to propagate the light through the waveguide (240) in dependence of wavelength such that a spatial distribution of the light at the distributing end (244) is dependent on wavelength of the light;
wherein each waveguide of the plurality of light propagating units has a cross-section parallel to the first surface, wherein the cross-section has a symmetrical shape defining a first size of the cross-section in a first direction and a second size of the cross-section in a second direction perpendicular to the first direction, wherein the first size is equal to the second size.

10. The imaging device according to claim 9, wherein each light propagation unit (220) is associated with at least four light sensitive elements (212) arranged in a square configuration in the detector (210) with the first and second directions of the waveguide (240) parallel with respective sides of the square configuration, wherein the spatial distribution of the light at the distributing end (244) of the waveguide (240) is incident onto the at least four light sensitive elements (212).

11. The imaging device according to claim 10, wherein each light sensitive element (212) is configured to receive light from at least two light propagating units (220).

12. The imaging device according to any one of claims 8-11, wherein the funnel element (130; 230) is asymmetrically arranged in relation to the waveguide (140; 240) such that a central funnel axis at the transmitting end (134; 234) is displaced from a central waveguide axis at the receiving end (142; 242).

13. The imaging device according to any one of claims 8-12, wherein the funnel element (130; 230) has a rectangular shape at the collecting end (132; 232), wherein a side of the funnel element (130; 230) is rotated in relation to a direction along a row of light sensitive elements (112; 212) by an angle in a range of 20-45°, such as in a range of 40-45°.

14. A semiconductor wafer structure (300), comprising:
a plurality of groups of light propagating units associated with a plurality of imaging devices (100; 200) according to any one of the preceding claims,
wherein the plurality of light propagating units is formed on a common substrate of the semiconductor wafer structure (300).

15. A method for wavelength dependent imaging, said method comprising:
collecting (402), by a plurality of light propagating unis, light incident at a collecting end of a respective light collecting element of each light propagating unit of the plurality of light propagating units;
propagating (404), for each light propagating unit, the light to a transmitting end of the light collecting element;
receiving (406), at a receiving end of a waveguide of each light propagating unit, the light from the transmitting end;
propagating (408), for each light propagating unit, the light to a distributing end of the waveguide, wherein the waveguide is a multimode waveguide, and wherein the propagating the light through the waveguide is dependent on wavelength such that a spatial distribution of the light at the distributing end is dependent on wavelength of the light;
wherein (i) the waveguide has a cross-section parallel to the first surface, wherein the cross-section has an elongate shape defining a first size of the cross-section in a first direction and a second size of the cross-section in a second direction perpendicular to the first direction, wherein the first size is larger than the second size, and the waveguides of the plurality of light propagating units are arranged with different orientations such that a first waveguide of a first light propagating unit is rotated in relation to a second waveguide of a second light propagating unit defining an angle between the first direction of the first light propagating unit and the first direction of the second light propagating unit or (ii) the light collecting element is a funnel element, wherein a cross-section of the collecting end is larger than a cross-section of the transmitting end, and wherein each waveguide of the plurality of light propagating units has a cross-section parallel to the first surface, wherein the cross-section has a symmetrical shape defining a first size of the cross-section in a first direction and a second size of the cross-section in a second direction perpendicular to the first direction, wherein the first size is equal to the second size; and
detecting (410), for each light propagating unit, the light at the distributing end, by at least two light sensitive elements of a plurality of light sensitive elements, such that each light sensitive element generates an electric signal dependent on an intensity of light incident onto the light sensitive element.
